# EUROPEAN PATENT SPECIFICATION

(11) **EP 4 246 151 B1**
(45) Date of publication and mention of the grant of the patent: **14.05.2025**
(21) Application number: 22162864.7
(22) Date of filing: 18.03.2022
(51) Int. Cl.: G01R 29/08, G01R 23/165

(54) **MEASUREMENT SYSTEM FOR A BROADBAND SIGNAL**
MESSSYSTEM FÜR EIN BREITBANDSIGNAL
SYSTÈME DE MESURE POUR UN SIGNAL À LARGE BANDE

(43) Date of publication of application: 20.09.2023
(73) Proprietor: Rohde & Schwarz GmbH & Co. KG, 81671 München (DE)
(72) Inventor: Woehrle, Michael, 86854 Amberg (DE); Maier, Thomas, 84428 Buchbach (DE)
(74) Representative: Novagraaf Group

(56) References cited:
- US-A1- 2010 220 778
- US-B1- 7 541 959
- SIM ZHI WEI ET AL: "Radiated spurious emission measurements using fast Fourier transform-based time domain scan", IET SCIENCE, MEASUREMENT AND TECHNOLOGY, THE INSTITUTION OF ENGINEERING AND TECHNOLOGY, MICHAEL FARADAY HOUSE, SIX HILLS WAY, STEVENAGE, HERTS. SG1 2AY, UK, vol. 9, no. 7, 1 October 2015 (2015-10-01), pages 882 - 889, XP006053859, ISSN: 1751-8822, DOI: 10.1049/IET-SMT.2014.0333
- GUO LIANPING ET AL: "Channelized broadband signal spectrum analysis based on weighted overlap-add structure", REVIEW OF SCIENTIFIC INSTRUMENTS, AMERICAN INSTITUTE OF PHYSICS, 2 HUNTINGTON QUADRANGLE, MELVILLE, NY 11747, vol. 87, no. 10, 25 October 2016 (2016-10-25), XP012213123, ISSN: 0034-6748, [retrieved on 20161025], DOI: 10.1063/1.4965879
- STEPHAN BRAUN ET AL: "A Real-Time Time-Domain EMI Measurement System for Full-Compliance Measurements According to CISPR 16-1-1", IEEE TRANSACTIONS ON ELECTROMAGNETIC COMPATIBILITY, IEEE SERVICE CENTER , NEW YORK , NY, US, vol. 50, no. 2, 1 May 2008 (2008-05-01), pages 259 - 267, XP011214094, ISSN: 0018-9375
- STORR WAYNE: "Bandpassfilter - Passives RC Filter Tutorial", 31 December 2018 (2018-12-31), pages 1 - 7, XP055961256, Retrieved from the Internet <URL:https://www.electronics-tutorials.ws/de/filtern/passiver-bandpassfilter.html> [retrieved on 20220915]

## Description

### Technical Field

The present disclosure relates to measurement of broadband signals, and in particular to a measurement system in this respect.

### Background Art

Measurement of broadband pulse signals, such as electromagnetic interference (EMI) measurement, requires a high dynamic range receiver due to a significant difference between a peak value of the pulse and a weighted indication of the detector within the resolution bandwidth. In other words, an achievable radio frequency (RF) bandwidth is limited by the dynamic range of the used components (e.g. 1 dB compression point of a mixer or amplifier, or signal-to-noise ratio (SNR) of an analog/digital converter).

This may be overcome by reducing a bandwidth at the critical components of the receiver with filters (preselection), the critical components including e.g. a first mixer of a heterodyne receiver or analog/digital converter at an intermediate frequency (IF) of a receiver or the baseband of a direct conversion receiver. Then, the measurement is done in a time-consuming sequential manner for every preselector filter path and measurement frequency. The prior art knows the document US 7 541 959 B1, which pertains to the conversion of analog signals to digital format, particularly applicable for capturing wideband signals where the desired dynamic range of the system cannot be achieved by existing analog to digital converters. It is based on channelizing the input signal and frequency down-converting to allow each band to be sampled at a lower rate, digitizing, and then reconstructing the signal.
Within a preselector filter bandwidth, the measurement may involve Fast Fourier Transform (FFT) methods to accelerate the measurement.

### Summary

In view of the above, the present disclosure aims to improve a measurement of broadband pulse signals of the background art. An objective is to shorten a test time.

The objective is achieved by the embodiments as defined by the appended independent claims. Preferred embodiments are set forth in the dependent claims and in the following description and drawings.

An aspect of the present disclosure relates to a measurement system for a broadband signal. The system comprises a cross-over network, including an input port for the broadband signal; a plurality of output ports; and a plurality of frequency dividers, being configured to supply respective sub-bands of the broadband signal to the plurality of output ports. The plurality of frequency dividers comprises one or more of a low-pass filter and a high-pass filter. The system further comprises a processing unit, being configured to analyze the respective sub-bands of the broadband signal concurrently. It is very beneficial that a wide frequency range is split up into smaller sub-bands, wherein each sub-band is analyzed simultaneously (=concurrently). Thereby it is possible to analyze a wide frequency span of for example 30 Mhz to 1000 MHz at once. This not only accelerates the measurement but makes it possible to detect any irregular occurring peaks at all. For EMI measurement, the chances of missing a peak the DUT emits, is significantly reduced. In fact, DUTs like vehicles can be put into different test modes (for example acceleration from 10m/s to 30m/s on a test bench), wherein the spectrum the DUT emits is continuously monitored on a wide range. Any peak, even if it only occurs once (for example at 25m/s) can be detected with the measurement system according to the invention.

The processing unit may comprise a respective analog/digital converter, ADC, unit for the respective sub-band. This also comes along with the technical effect that all the sub-bands can be analyzed in parallel wherein each ADC only receives a certain bandwidth. Preferably, the RF signal of the respective sub-band is not mixed down before fed to the respective ADC. Instead the respective ADC is configured to digitize the RF signal of the assigned sub-band in the original frequency but with a reduced bandwidth of that sub-band.

The broadband signal may comprise a baseband signal.

Alternatively, the broadband signal may comprise an intermediate frequency, IF, signal.

The respective ADC unit for the respective sub-band may be configured to digitally sample the respective sub-band of the IF signal.

The respective ADC unit for the respective sub-band may be configured to digitally mix down the respective sub-band of the IF signal to the baseband.

The respective ADC unit for the respective sub-band may be configured to decimate a sampling rate of the respective sub-band of the IF signal. For example, the ADC can be operated at 3 GHz with a resolution of 16 bit, but the decimation may result in a reduced data rate, such as e.g. 500 MHz.

The processing unit may comprise a respective Fast Fourier Transform, FFT, unit for the respective sub-band. The respective FFT unit may be configured to perform a first plurality of concurrent FFT calculations in accordance with a second plurality of frequency bins being spread over the respective sub-band.

The respective frequency bin may be associated with at least 20.000, 40.000, 80.000, 160.000, 250.000, 320.000, 400.000 or 480.000 FFT calculations per second.

The processing unit may comprise a respective detector unit for the respective sub-band; and the respective detector unit may be configured to perform a plurality of concurrent analyses of the respective sub-band in respect of one or more detection criteria.

The respective detector unit for the respective sub-band may comprise a number of detectors for the respective frequency bin.

The respective detector unit for the respective sub-band may comprise a plurality of concurrently operable detectors for the respective frequency bin. In that case, all the frequency bins obtained from all the sub-bands are analyzed in parallel by the detectors.

A first detector of the plurality of detectors of the respective frequency bin may be configured for peak detection; a second detector of the plurality of detectors of the respective frequency bin may be configured for quasi-peak detection; and a third detector of the plurality of detectors of the respective frequency bin may be configured for average detection. In that case, each frequency bin can be analyzed by a plurality of detectors at the same time.

The cross-over network may further comprise an amplifier arranged between subsequent frequency dividers of the plurality of frequency dividers.

The measurement system may further comprise a display unit. The processing unit may further be configured to display the respective analyzed sub-bands on the display unit.

### Advantageous Effects

According to the present disclosure, a broadband signal, such as a baseband signal or an IF signal of a heterodyne receiver, may be split into sub-bands, i.e., into a plurality of signals of limited bandwidth, which may be digitized and processed (e.g., digital down converted) concurrently.

This has the following advantages:
- The sub-bands have limited bandwidths and therefore achieve a required high dynamic range for broadband pulse signals (in general, components like mixers, amplifiers and analog/digital converters should only receive a limited part of the broadband signal so that a high accuracy is achieved).
- The sub-bands may be leveled separately: a strong signal within one sub-band doesn't limit a sensitivity of the other sub-bands.
- The sub-bands may be processed concurrently to one another, resulting in a speed-up of the broadband measurement by a factor of N (corresponding to the quantity of the sub-bands).
- Higher dynamic in comparison to a system with one band with the same bandwidth.

### Brief Description of Drawings

The above-described aspects and implementations will now be explained with reference to the accompanying drawings, in which the same or similar reference numerals designate the same or similar elements.

The features of these aspects and implementations may be combined with each other unless specifically stated otherwise.

The drawings are to be regarded as being schematic representations, and elements illustrated in the drawings are not necessarily shown to scale. Rather, the various elements are represented such that their function and general purpose become apparent to those skilled in the art.
- FIG. 1: illustrates a measurement system in accordance with the present disclosure; and
- FIG. 2: illustrates a cross-over network in accordance with the present disclosure of the measurement system of FIG. 1.

### Detailed Descriptions of Drawings

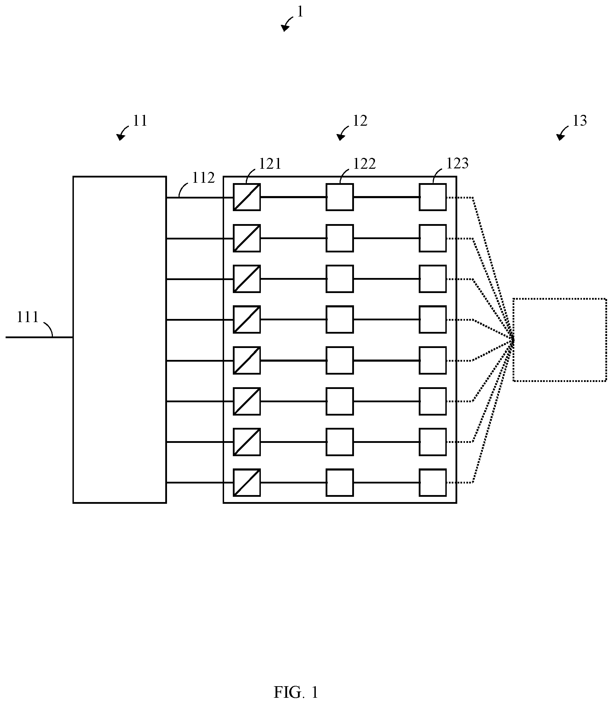

FIG. 1 illustrates a measurement system 1 in accordance with the present disclosure for a broadband signal.

The broadband signal to be analyzed may comprise a baseband signal, or an intermediate frequency, IF, signal, particularly of a heterodyne receiver. Especially for EMI measurements, a broad frequency range has to be measured. This in turn requires a high dynamic range of the receiver due to a significant difference between the peak values of the signal. In general, a pulse signal as well as a modulated signal have broad spectra.

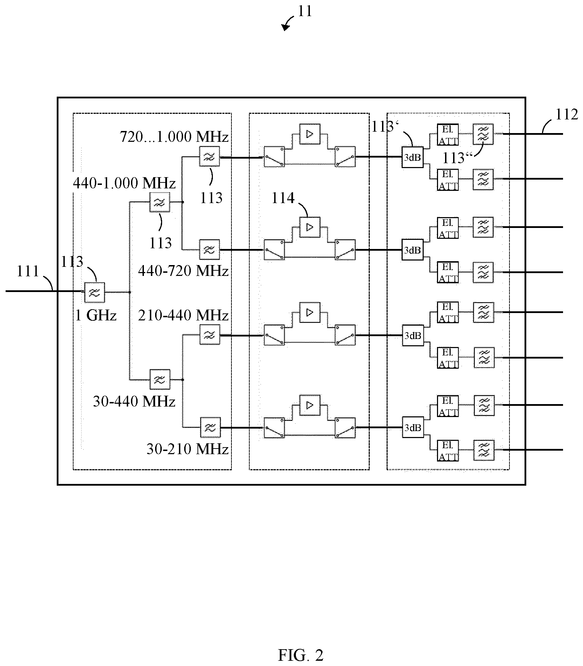

The system 1 comprises a cross-over network 11, including an input port 111 for the broadband signal, and a plurality of output ports 112. As will be explained in more detail in connection with FIG. 2 below, the cross-over network 11 is configured to supply respective sub-bands of the broadband signal to the plurality of output ports 112. In other words, the cross-over network 11is configured to preselect the respective sub-band of the broadband signal of a respective output port 11.

The system 1 further comprises a processing unit 12, being configured to analyze the respective sub-bands of the broadband signal concurrently. Concurrently means that the respective sub-bands of the broadband signal are analyzed at the same time by dedicated means.

To this end, the processing unit 12 may comprise a respective analog/digital converter, ADC, unit 121 for the respective sub-band.

The respective ADC unit 121 for the respective sub-band may be configured to digitally sample the respective sub-band of the IF signal. As such, the ADC units 121 are very fast (in compliance with the Shannon theorem) and operable on respective sub-bands of the original frequency band (for example 30 MHz to 1.000 MHz) of the broadband signal. The signal paths upstream the ADC units 121 are free of mixers.

Optionally, the respective ADC unit 121 for the respective sub-band may be configured to digitally mix down the respective sub-band of the IF signal to the baseband.

Optionally, the respective ADC unit 121 for the respective sub-band may be configured to decimate a sampling rate of the respective sub-band of the IF signal.

The processing unit 12 may further comprise a respective Fast Fourier Transform, FFT, unit 122 for the respective sub-band. The respective FFT unit 122 may be configured to perform a first plurality of concurrent FFT calculations in accordance with a second plurality of frequency bins being spread over the respective sub-band.

The respective FFT unit 122 may be arranged downstream of the respective ADC unit 121. The respective FFT unit 122 may be configured to perform a 1024, 2048 or 4096-point FFT, for example.

The respective frequency bin may represent 60 kHz or 120 kHz of bandwidth, for example, and may be associated with preferably more than 20.000, 40.000, 80.000, 160.000, 250.000, 320.000 or more than 400.000 FFT calculations per second. More preferably the respective frequency bin is associated with (at least) 480.000 FFT calculations per second.

The processing unit 12 may comprise a respective detector unit 123 for the respective sub-band.

The detector unit 123 may be arranged downstream of the respective FFT unit 122. The respective detector unit 123 may be configured to perform a plurality of concurrent analyses of the respective sub-band in respect of one or more detection criteria, such as peak detection, quasi-peak detection and average detection.

In particular, the respective detector unit 123 for the respective sub-band may comprise a plurality of concurrently operable detectors for the respective frequency bin.

For example, a first detector of the plurality of detectors of the respective frequency bin may be configured for peak detection; a second detector of the plurality of detectors of the respective frequency bin may be configured for quasi-peak detection; and a third detector of the plurality of detectors of the respective frequency bin may be configured for average detection.

The measurement system 1 may further comprise a display unit 13. The processing unit 12 may further be configured to display the respective analyzed sub-bands on the display unit 13.

Assuming a bandwidth of 60 kHz per frequency bin, the frequency band between 30 MHz and 1.000 MHz (according to CISPR standard) requires a quantity of (1.000 MHz - 30 MHz) / 60 kHz = 16.166 frequency bins. Each frequency bin may be associated with for example 480.000 FFT calculations per second, and an exemplary plurality of three concurrently operable detectors may be used for the respective frequency bin.

FIG. 2 illustrates a cross-over network 111 in accordance with the present disclosure of the measurement system 1 of FIG. 1.

The cross-over network 11 already mentioned in connection with FIG. 1 includes a plurality of frequency dividers 113, being configured to supply respective sub-bands of the broadband signal to the plurality of output ports 112. As used herein, a frequency divider may refer to a frequency-selective filter.

The plurality of frequency dividers 113 comprises one or more of a low-pass filter and a high-pass filter as follows:
Starting from the input port 111, a low-pass filter may be provided as a first frequency divider 113. Preferably frequencies below 1 GHz can pass without significant attenuation. As such, a frequency band of interest, such as 30 MHz to 1.000 MHz according to the CISPR standard, can be analyzed.

Then a first splitting stage may be provided downstream of the first frequency divider 113. The first splitting stage may comprise a plurality of frequency-selective dividers 113 (in the embodiment there are two dividers, one of them being referenced as such). The first splitting stage may supply frequency bands of 30 to 440 MHz and 440 to 1.000 MHz.

A second splitting stage may be provided downstream the first splitting stage. The second splitting stage may comprise a plurality of frequency-selective dividers 113 (in the embodiment there are four dividers, one of them being referenced as such). The second splitting stage may further subdivide the frequency bands supplied by the first splitting stage. The second splitting stage may supply frequency bands of 30 to 210 MHz, 210 to 440 MHz, 440 to 720 MHz, and 720 to 1.000 MHz, respectively.

The first and second splitting stages are configured in such a way that the input port 111 of the cross-over network 11 matches a predefined impedance. This is easier to achieve if high-pass filters and low-pass filters are used rather than band-pass filters, because the voltage standing wave ratio (VSWR) must meet particular criteria. Each of the filters implies a signal attenuation preferably as low as 0,5 to 1,0 dB.

A third splitting stage may be provided downstream the second splitting stage. The third splitting stage may comprise a plurality of composite dividers 113', 113" (in the embodiment there are four such dividers, one of them being referenced as such). A composite divider 113', 113" may comprise a series connection of a frequency-agnostic 3dB coupler 113' (i.e., a power splitter) and a frequency-selective filter 113", which jointly behave as a frequency-selective frequency divider.

The dividers 113', 113" of the third splitting stage are connected to the frequency dividers 113 of the second splitting stage directly or indirectly. The dividers of the third splitting stage may further include attenuators for levelling out any power level imbalances among the plurality of sub-bands, since the power levels of the sub-bands should be the same. The 3dB couplers 113' increase an isolation between the sub-bands.

The third/last splitting stage may supply the respective sub-bands of the broadband signal to the plurality of output ports 112. According to the example of FIG. 2, eight sub-bands are available at the output ports 112 of the cross-over network 11. Of course, a different number of sub-bands could be provided.

The cross-over network 11 may further comprise an amplifier 114 arranged between subsequent frequency dividers 113, 113', 113" of the plurality of frequency dividers 113. The attenuation added before an amplifier should be kept to a minimum. As such, preferably no power dividers (for example 3dB-couplers) or the like are used to split up the frequency before the use of an amplifier 114. Instead, low-pass filters and/or high-pass filters should be used.

Between the first splitting stage and the second splitting stage, a pre-amplifier (not shown) such as a low-noise amplifier (LNA) may selectively be inserted into the signal path by means of switching devices. Such a pre-amplifier may be added after each frequency divider 113 of the first splitting stage.

Between the second splitting stage and the third splitting stage, (pre-)amplifiers may be arranged (for example an LNA). The amplifiers may be inserted into the signal path by switching devices (as shown). The pre-amplifier is used only for analysis of low-power broadband signals. The amplifier could amplify the signal by a factor of 20 dB, for example.

## Claims

1. Measurement system (1) for a broadband signal, comprising
a cross-over network (11), including
an input port (111) for the broadband signal;
a plurality of output ports (112); and
a plurality of frequency dividers (113), being configured to supply respective sub-bands of the broadband signal to the plurality of output ports (112); and
a processing unit (12), being configured to analyze the respective sub-bands of the broadband signal concurrently;
the plurality of frequency dividers (113) comprising one or more of a low-pass filter and a high-pass filter.

2. The measurement system (1) of claim 1,
the processing unit (12) comprising a respective analog/digital converter, ADC, unit (121) for the respective sub-band.

3. The measurement system (1) of claim 1 or claim 2,
the broadband signal comprising a baseband signal.

4. The measurement system (1) of claim 1 or claim 2,
the broadband signal comprising an intermediate frequency, IF, signal.

5. The measurement system (1) of claim 4,
the respective ADC unit (121) for the respective sub-band being configured to digitally sample the respective sub-band of the IF signal.

6. The measurement system (1) of claim 4,
the respective ADC unit (121) for the respective sub-band being configured to digitally mix down the respective sub-band of the IF signal to the baseband.

7. The measurement system (1) of claim 4 or claim 6,
the respective ADC unit (121) for the respective sub-band being configured to decimate a sampling rate of the respective sub-band of the IF signal.

8. The measurement system (1) of any one of the preceding claims,
the processing unit (12) comprising a respective Fast Fourier Transform, FFT, unit (122) for the respective sub-band; and
the respective FFT unit (122) being configured to perform a first plurality of concurrent FFT calculations in accordance with a second plurality of frequency bins being spread over the respective sub-band.

9. The measurement system (1) of claim 8,
the respective frequency bin being associated with at least 20.000, 40.000, 80.000, 160.000, 250.000, 320.000, 400.000 or 480.000 FFT calculations per second.

10. The measurement system (1) of claim 8 or claim 9,
the processing unit (12) comprising a respective detector unit (123) for the respective sub-band; and
the respective detector unit (123) being configured to perform a plurality of concurrent analyses of the respective sub-band in respect of one or more detection criteria.

11. The measurement system (1) of claim 10,
the respective detector unit (123) for the respective sub-band comprising a number of detectors for the respective frequency bin.

12. The measurement system (1) of claim 10,
the respective detector unit (123) for the respective sub-band comprising a plurality of concurrently operable detectors for the respective frequency bin.

13. The measurement system (1) of claim 12,
a first detector of the plurality of detectors of the respective frequency bin being configured for peak detection;
a second detector of the plurality of detectors of the respective frequency bin being configured for quasi-peak detection; and
a third detector of the plurality of detectors of the respective frequency bin being configured for average detection.

14. The measurement system (1) of any one of the preceding claims,
the cross-over network (11) further comprising
an amplifier (114) arranged between subsequent frequency dividers (113, 113', 113") of the plurality of frequency dividers (113).

15. The measurement system (1) of any one of the preceding claims, further comprising
a display unit (13);
the processing unit (12) further being configured to display the respective analyzed sub-bands on the display unit (13).

## Patentansprüche

1. Messsystem (1) für ein Breitbandsignal, umfassend
eine Frequenzweiche (11), einschließlich
einen Eingangsanschluss (111) für das Breitbandsignal;
eine Vielzahl von Ausgangsanschlüssen (112); und
eine Vielzahl von Frequenzteilern (113), die konfiguriert sind, um entsprechende Teilbänder des Breitbandsignals an die Vielzahl von Ausgangsanschlüssen (112) zu liefern; und
eine Verarbeitungseinheit (12), die konfiguriert ist, um die entsprechenden Teilbänder des Breitbandsignals zeitgleich zu analysieren;
die Vielzahl von Frequenzteilern (113) umfassend einen oder mehrere von einem Tiefpassfilter und einem Hochpassfilter.

2. Messsystem (1) nach Anspruch 1,
die Verarbeitungseinheit (12) umfassend eine entsprechende Analog-Digital-Umsetzereinheit, ADC-Einheit, (121), für das entsprechende Teilband.

3. Messsystem (1) nach Anspruch 1 oder 2,
das Breitbandsignal umfassend ein Basisbandsignal.

4. Messsystem (1) nach Anspruch 1 oder 2,
das Breitbandsignal umfassend ein Zwischenfrequenzsignal (ZF-Signal).

5. Messsystem (1) nach Anspruch 4,
wobei die entsprechende ADC-Einheit (121) für das entsprechende Teilband konfiguriert ist, um das entsprechende Teilband des ZF-Signals digital abzutasten.

6. Messsystem (1) nach Anspruch 4,
wobei die entsprechende ADC-Einheit (121) für das entsprechende Teilband konfiguriert ist, um das entsprechende Teilband des ZF-Signals auf das Basisband digital abzumischen.

7. Messsystem (1) nach Anspruch 4 oder 6,
wobei die entsprechende ADC-Einheit (121) für das entsprechende Teilband konfiguriert ist, um eine Abtastrate des entsprechenden Teilbands des ZF-Signals zu dezimieren.

8. Messsystem (1) nach einem der vorstehenden Ansprüche,
die Verarbeitungseinheit (12) umfassend eine entsprechende Fast Fourier Transform-Einheit, FFT-Einheit, (122), für das entsprechende Teilband; und
wobei die entsprechende FFT-Einheit (122) konfiguriert ist, um eine erste Vielzahl zeitgleicher FFT-Berechnungen gemäß einer zweiten Vielzahl von Frequenzbereichen durchzuführen, die über das entsprechende Teilband verteilt sind.

9. Messsystem (1) nach Anspruch 8,
wobei dem entsprechenden Frequenzbereich mindestens 20.000, 40.000, 80.000, 160.000, 250.000, 320.000, 400.000 oder 480.000 FFT-Berechnungen pro Sekunde zugeordnet sind.

10. Messsystem (1) nach Anspruch 8 oder 9,
die Verarbeitungseinheit (12) umfassend eine entsprechende Detektoreinheit (123) für das entsprechende Teilband; und
wobei die entsprechende Detektoreinheit (123) konfiguriert ist, um eine Vielzahl zeitgleicher Analysen des entsprechenden Teilbandes entsprechend eines oder mehrerer Erkennungskriterien durchzuführen.

11. Messsystem (1) nach Anspruch 10,
die entsprechende Detektoreinheit (123) für das entsprechende Teilband umfassend eine Anzahl von Detektoren für den entsprechenden Frequenzbereich.

12. Messsystem (1) nach Anspruch 10,
die entsprechende Detektoreinheit (123) für das entsprechende Teilband umfassend eine Vielzahl zeitgleich betreibbarer Detektoren für den entsprechenden Frequenzbereich.

13. Messsystem (1) nach Anspruch 12,
wobei ein erster Detektor der Vielzahl von Detektoren des entsprechenden Frequenzbereichs für eine Spitzenerkennung konfiguriert ist;
wobei ein zweiter Detektor der Vielzahl von Detektoren des entsprechenden Frequenzbereichs für eine Quasi-Spitzenerkennung konfiguriert ist; und
wobei ein dritter Detektor der Vielzahl von Detektoren des entsprechenden Frequenzbereichs für eine Durchschnittserkennung konfiguriert ist.

14. Messsystem (1) nach einem der vorstehenden Ansprüche,
die Frequenzweiche (11) ferner umfassend
einen Verstärker (114), der zwischen nachfolgenden Frequenzteilern (113, 113', 113") der Vielzahl von Frequenzteilern (113) angeordnet ist.

15. Messsystem (1) nach einem der vorstehenden Ansprüche, ferner umfassend
eine Anzeigeeinheit (13);
wobei die Verarbeitungseinheit (12) ferner konfiguriert ist, um die entsprechenden analysierten Teilbänder auf der Anzeigeeinheit (13) anzuzeigen.

## Revendications

1. Système de mesure (1) destiné à un signal à large bande, comprenant
un réseau de croisement (11), comportant
un port d'entrée (111) pour le signal à large bande ;
une pluralité de ports de sortie (112) ; et
une pluralité de diviseurs de fréquence (113), configurés pour fournir des sous-bandes respectives du signal à large bande à la pluralité de ports de sortie (112) ; et
une unité de traitement (12), configurée pour analyser simultanément les sous-bandes respectives du signal à large bande ;
la pluralité de diviseurs de fréquence (113) comprenant un ou plusieurs d'un filtre passe-bas et d'un filtre passe-haut.

2. Système de mesure (1) selon la revendication 1,
l'unité de traitement (12) comprenant une unité de convertisseur analogique/numérique, ADC, respective (121) pour la sous-bande respective.

3. Système de mesure (1) selon la revendication 1 ou la revendication 2,
le signal à large bande comprenant un signal en bande de base.

4. Système de mesure (1) selon la revendication 1 ou la revendication 2,
le signal à large bande comprenant un signal de fréquence intermédiaire, **FI.**

5. Système de mesure (1) selon la revendication 4,
l'unité ADC (121) respective pour la sous-bande respective étant configurée pour échantillonner numériquement la sous-bande respective du signal IF.

6. Système de mesure (1) selon la revendication 4,
l'unité ADC respective (121) pour la sous-bande respective étant configurée pour mélanger numériquement la sous-bande respective du signal IF à la bande de base.

7. Système de mesure (1) selon la revendication 4 ou la revendication 6,
l'unité ADC (121) respective pour la sous-bande respective étant configurée pour décimer une fréquence d'échantillonnage de la sous-bande respective du signal IF.

8. Système de mesure (1) selon l'une quelconque des revendications précédentes,
l'unité de traitement (12) comprenant une unité de transformation de Fourier rapide, TFR, (122) pour la sous-bande respective ; et
l'unité TFR respective (122) étant configurée pour effectuer une première pluralité de calculs TFR simultanés en fonction d'une seconde pluralité de cellules de fréquence réparties sur la sous-bande respective.

9. Système de mesure (1) selon la revendication 8,
le canal de fréquence respectif étant associé à au moins 20 000, 40 000, 80 000, 160 000, 250 000, 320 000, 400 000 ou 480 000 calculs TFR par seconde.

10. Système de mesure (1) selon la revendication 8 ou la revendication 9,
l'unité de traitement (12) comprenant une unité de détection respective (123) pour la sous-bande respective ; et
l'unité de détection respective (123) étant configurée pour effectuer une pluralité d'analyses simultanées de la sous-bande respective en fonction d'un ou de plusieurs critères de détection.

11. Système de mesure (1) selon la revendication 10,
l'unité de détection respective (123) pour la sous-bande respective comprenant un certain nombre de détecteurs pour la cellule de fréquence respective.

12. Système de mesure (1) selon la revendication 10,
l'unité de détection respective (123) pour la sous-bande respective comprenant une pluralité de détecteurs utilisables simultanément pour la cellule de fréquence respective.

13. Système de mesure (1) selon la revendication 12,
un premier détecteur de la pluralité de détecteurs de la cellule de fréquence respective étant configuré pour la détection de crêtes ;
un deuxième détecteur de la pluralité de détecteurs de la cellule de fréquence respective étant configuré pour la détection de quasi-crêtes ; et
un troisième détecteur de la pluralité de détecteurs de la cellule de fréquence respective étant configuré pour la détection de la moyenne.

14. Système de mesure (1) selon l'une quelconque des revendications précédentes,
le réseau de croisement (11) comprenant en outre
un amplificateur (114) agencé entre des diviseurs de fréquence suivants (113, 113', 113") de la pluralité de diviseurs de fréquence (113).

15. Système de mesure (1) selon l'une quelconque des revendications précédentes, comprenant en outre
une unité d'affichage (13) ;
l'unité de traitement (12) étant en outre configurée pour afficher les sous-bandes analysées respectives sur l'unité d'affichage (13).
